Europäisches Patentamt

European Patent Office

Office européen des brevets

(19)

(11) Numéro de publication: **0 015 547**
**A1**

## (12) DEMANDE DE BREVET EUROPEEN

(21) Numéro de dépôt: 80101113.1

(22) Date de dépôt: 05.03.80

(51) Int. Cl.³: **H 01 L 23/44,** H 01 L 23/40, H 01 L 25/14, H 01 L 23/42

(30) Priorité: 12.03.79 FR 7906235

(43) Date de publication de la demande: 17.09.80
Bulletin 80/19

(84) Etats contractants désignés: **CH DE FR GB IT SE**

(71) Demandeur: **Société Anonyme dite: ALSTHOM-ATLANTIQUE, 38, Avenue Kléber, F-75784 Paris Cedex 16 (FR)**

(72) Inventeur: **Masselin, Michel, 30, rue du Général Exelmans, F-78140 Velizy Villacoublay (FR)**

(74) Mandataire: **Weinmiller, Jürgen et al, Zeppelinstrasse 63, D-8000 München 80 (DE)**

(54) Montage de semiconducteurs de puissance refroidis par un fluide réfrigérant.

(57) Montage permettant de réduire l'encombrement et d'améliorer la maintenance du dispositif.

Il comporte deux plateaux d'extrémité (9, 10) reliés entre eux par un arbre soudé (30) et une pluralité de colonnes (1, 2) de semiconducteurs pouvant être serrés d'une façon indépendante, l'un des plateaux (10) servant à ce serrage et l'autre plateau (5) servant de couvercle à l'enceinte contenant le montage.

Application: alimentation de moteurs électriques de chemis de fer.

Montage de semiconducteurs de puissance refroidis par un fluide réfrigérant

La présente invention concerne un montage de semiconducteurs de puissance refroidis par un fluide réfrigérant.

Il est connu par le brevet français n° 75 30527 de constituer des colonnes de diodes ou de thyristors baignant dans un hydrocarbure fluoré et contenues dans une enceinte. Ces colonnes disposées en étoile sont enserrées par deux plateaux d'extrémité disposés de part et d'autre d'un tirant central vissé à ses deux extrémités par deux écrous. Les deux écrous servent à assurer une pression globale, sur les colonnes de diodes et de thyristors, suffisante pour exercer dans chaque colonne un contact intime entre les composants. Le couvercle de l'enceinte en matière isolante comporte d'une part des tiges filetées pour soutenir l'ensemble des colonnes par l'un des plateaux d'extrémité, d'autre part une pluralité de bornes pour alimenter les colonnes parallèlement à celles-ci. Le dispositif présente cependant certains inconvénients. Le serrage commun aux trois colonnes impose l'utilisation de rondelles exerçant une charge importante puisqu'elle représente la somme des charges de chaque colonne. Le montage est délicat à réaliser lorsque les charges ne sont pas identiques sur chacune des colonnes. De plus lors de l'échange d'un semiconducteur, les deux colonnes non concernées par cet échange restent en équilibre instable sans aucune tenue mécanique pendant toute la durée de l'opération. Enfin les connexions de puissance d'entrée et de sortie sont implantées hors de l'encombrement des colonnes de semiconducteurs ce qui entraine une perte de place sur le couvercle de l'enceinte donc une limitation du nombre des bornes d'alimentation.

Le montage selon la présente invention remédie à ces divers inconvénients. Dans celui-ci en effet, les colonnes de semiconducteurs pour un même encombrement de l'enceinte peuvent être plus nombreuses, la maintenance des semiconducteurs de chaque colonne peut être effectuée d'une façon plus aisée et la charge d'une colonne peut être réglée indépendamment des autres colonnes.

La présente invention a pour objet un montage de semiconducteurs de puissance refroidis par un fluide réfrigérant comportant des colonnes de semiconducteurs espacés de blocs de cuivre massifs constituant les électrodes, enserrés par un premier et un deuxième plateaux d'extrémité, l'ensemble étant disposé dans une enceinte contenant le fluide réfrigérant, caractérisé en ce que ledit premier plateau d'extrémité constitue le couvercle de l'enceinte et que ledit deuxième plateau d'extrémité comporte pour chacune des colonnes des moyens de serrage indépendants.

Dans une réalisation préférée de l'invention lesdits premier et deuxième plateaux sont tous les deux métalliques et sont solidaires l'un de l'autre par un arbre métallique soudé sur chacun des plateaux.

Selon une autre particularité de cette réalisation préférée de l'invention ledit premier plateau métallique comporte des traversées isolantes disposées chacune dans l'axe desdites colonnes.

Selon une autre particularité de cette réalisation préférée de l'invention ledit moyen de serrage d'une colonne est constitué d'une vis dont le filetage coopère avec ledit deuxième plateau et qui fait intervenir une pression sur des rondelles calibrées agissant sur un guide de rondelle disposé à l'extrémité de la colonne.

En se référant aux figures schématiques 1 à 3 ci-jointes on va décrire ci-après un exemple donné à titre purement illustratif et nullement limitatif de l'invention. Les mêmes éléments représentés sur plusieurs de ces figures portent sur toutes celles-ci les mêmes références.

La figure 1 représente une vue de dessus schématique du montage de semiconducteurs selon l'invention.

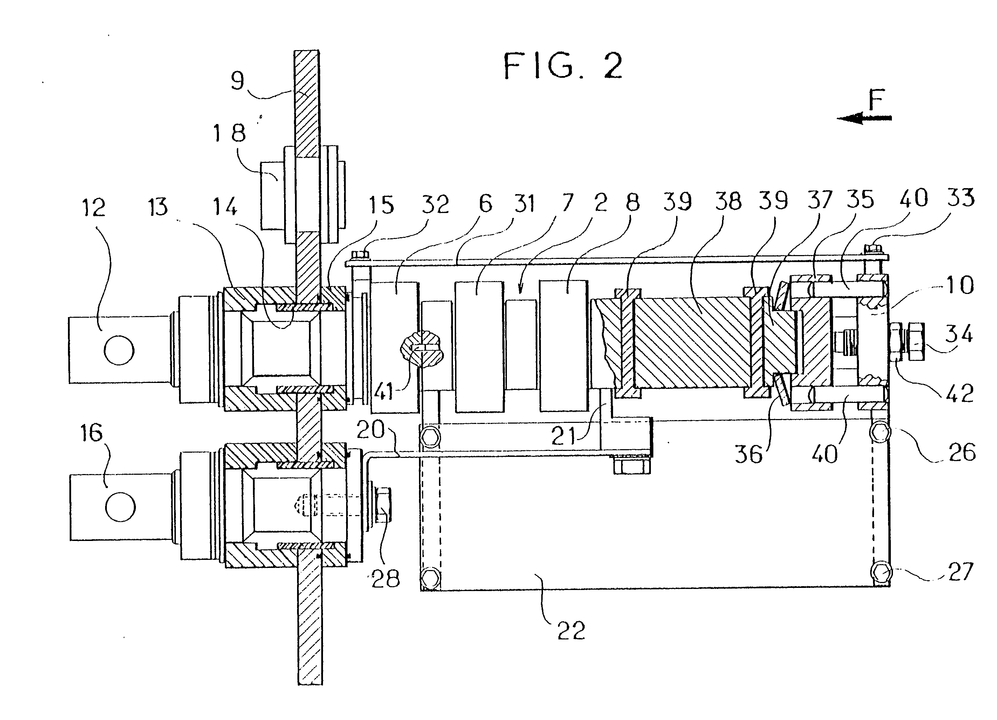

La figure 2 représente une vue schématique en élévation partiellement en coupe du même montage.

La figure 3 représente une vue schématique de côté selon F de la figure 2.

Comme on peut le voir sur les figures, deux colonnes 1 et 2 respectivement de diodes 3, 4, 5 et de thyristors 6, 7, 8 disposés en série sont enserrées par deux plateaux d'extrémité 9 et 10 métalliques en acier inoxydable ou analogue. Le plateau 9, par exemple, de forme octogonale, sert de couvercle à l'enceinte, non représentée, contenant le montage et un liquide de refroidissement. Le plateau 9 comporte des bornes de sortie 11 et 12 de la tension redressée disposées dans l'axe des colonnes 1 et 2. Les bornes de sortie 11 et 12 sont isolées du plateau 9 par trois manchons tels que 13, 14, 15 en matière plastique.

0015547

Des bornes d'alimentation en puissance 16, 17 sont également disposées sur le couvercle 9 qu'elles traversent par des passages isolants obtenus au moyen de manchons semblables aux manchons 13, 14, 15. Des bornes d'alimentation 18, 19 des gâchettes des thyristors 6, 7, 8 traversent le couvercle 9 tout en étant isolée électriquement de celui-ci. Les bornes 16, 17, 18, 19 sont disposées de part et d'autre des bornes 11 et 12 en dehors des axes des colonnes 1 et 2.

Comme les bornes de sortie 11 et 12 sont disposées chacune dans l'axe des colonnes 1 et 2 l'encombrement sur le couvercle 9 est moindre et il en résulte la possibilité de disposer un grand nombre de bornes de sortie et par conséquent des colonnes de semiconducteurs. Les bornes d'alimentation telles que 16 permettent d'accéder par des connexions telles que 20 et 21 aux électrodes des composants tels que 6, 7, 8. Une plaque portant un circuit imprimé tel que 22 ou 23 relié par des entretoises 24, 25 vissées par des vis 26, 27 permet de réaliser des fonctions électriques de protection.

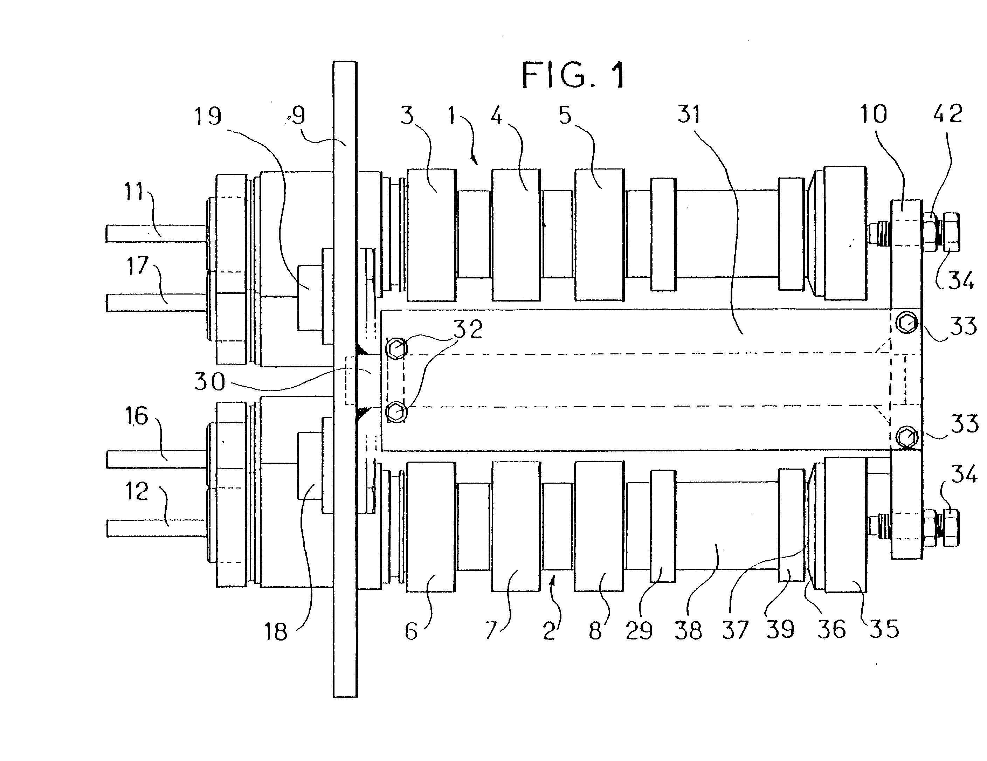

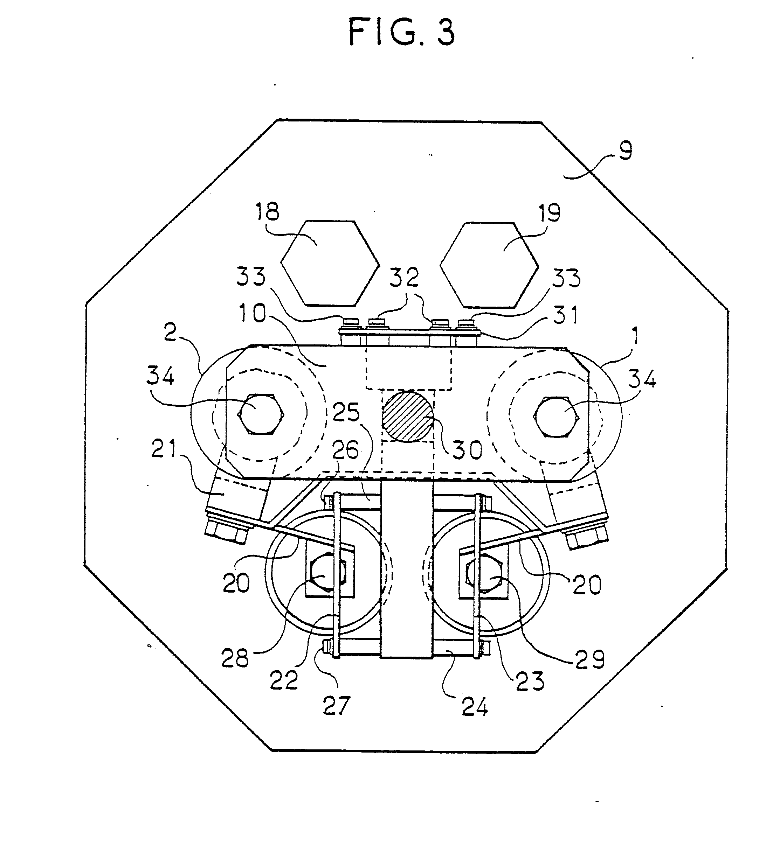

Sur les figures 1 et 3 on voit que le couvercle 9 et le plateau d'extrémité 10 sont solidaires l'un de l'autre par un arbre 30 de même métal que les plateaux 9 et 10 et brasé à ceux-ci à ses deux extrémités. L'arbre 30 est disposé avantageusement au centre de symétrie des plateaux 9 et 10. Une plaquette de circuit imprimé 31 est fixée entre les deux colonnes 1 et 2, d'une part, par les vis 33 sur le plateau 10 et, d'autre part, par les vis 32 et des entretoises sur l'arbre 30. La plaquette 31 sert à distribuer à partir des bornes 18 et 19 les courants de commande des gâchettes des thyristors 6, 7, 8.

Le moyen de serrage de chacune des colonnes 1 et 2 est réalisé au moyen de vis 34 et contre-écrou 41 traversant un filetage du plateau 10 et appuyant sur une pièce de serrage 35 agissant sur une pluralité de rondelles 36 élastiques dont la quantité est déterminée en fonction de la pression exigée pour chacune des colonnes. Les rondelles 36 sont guidées par un guide-rondelles 37 prenant appui sur un plot 38 et les composants 6, 7, 8 à travers des séparateurs isolants tel que 39. Il en résulte qu'on peut isoler électriquement les composants faisant partie des colonnes 1 et 2. Afin d'empêcher la rotation des

0015547

éléments de la colonne 1 ou 2, au moment du serrage de la vis 34, des goupilles 40 sont disposées entre le plateau 10 et la pièce de serrage 35.

Afin d'améliorer la stabilité mécanique des éléments de la colonne 1 ou 2, des goupilles telles que 41 sont disposées entre les composants adjacents tels que 6 et 7.

Le montage selon la présente invention permet de grouper d'une façon indépendante des colonnes d'éléments électroniques dont le refroidissement collectif est assuré par un hydrocarbure fluoré. Les applications sont du domaine des équipements électroniques des chemins de fer notamment pour la commande des moteurs électriques.

0015547

- 5 -

REVENDICATIONS

1/ Montage de semiconducteurs de puissances refroidis par un fluide réfrigérant comportant des colonnes de semiconducteurs espacés de blocs de cuivre massifs constituant les électrodes, enserrées entre un premier et un deuxième plateaux d'extrémité, l'ensemble étant disposé dans une enceinte contenant le fluide régrigérant, caractérisé en ce que ledit premier plateau (9) d'extrémité constitue le couvercle de l'enceinte et que ledit deuxième plateau (10) d'extrémité comporte pour chacune des colonnes (1, 2) des moyens de serrage (34, 42) indépendants associés à l'un des plateaux d'extrémité.

2/ Montage de semiconducteurs selon la revendication 1, caractérisé par le fait que lesdits premier et deuxième plateaux (5, 10) sont tous les deux métalliques et sont solidaires l'un de l'autre par un arbre métallique (30) soudé sur chacun des plateaux (9, 10).

3/ Montage de semiconducteurs selon la revendication 2, caractérisé par le fait que ledit premier plateau (9) métallique comporte des traversées (13, 14, 15) isolantes disposées chacune dans l'axe desdites colonnes (1, 2).

4/ Montage de semiconducteurs selon la revendication 3, ledit moyen de serrage d'une colonne étant constitué d'une vis 34 dont le filetage coopère avec ledit deuxième plateau (10), caractérisé par le fait qu'il fait intervenir une pression sur des rondelles (36) calibrées agissant sur un guide de rondelle (37) disposé à l'extrémité de la colonne (1, 2).

5/ Montage de semiconducteurs selon la revendication 4, caractérisé par le fait que ledit bloc de cuivre constituant l'électrode est séparé dudit guide de rondelles par au moins un séparateur isolant.

0015547

FIG. 1

FIG. 2

0015547

# FIG. 3

| Catégorie | Citation du document avec indication, en cas de besoin, des parties pertinentes | Revendica-tion concernée | CLASSEMENT DE LA DEMANDE (Int. Cl. ³) |
|---|---|---|---|
| | **DOCUMENTS CONSIDERES COMME PERTINENTS** | | |
| | IBM TECHNICAL DISCLOSURE BULLETIN vol. 17, no. 4, septembre 1974 New York US H.F. TEPPER: "Packaging for a large memory system", pages 987-988 * Figure 2, page 987, 3e alinéa * | 1,3 | H 01 L 23/44 23/40 25/14 23/42 |
| | CH - A - 554 601 (IBM) * Figure 1, revendication; sous-revendications 4,5 * | 1 | |
| | US - A - 4 010 489 (GENERAL MO-TORS) * Figure 1, colonne 2, ligne 66 - colonne 3, ligne 36 * | 1 | **DOMAINES TECHNIQUES RECHERCHES (Int. Cl. ³)** H 01 L 23/44 23/40 25/14 23/42 |
| | US - A - 3 573 574 (GENERAL MO-TORS) * Figure 1, colonne 4, ligne 62 - colonne 5, ligne 54 * | 1,2 | |
| | DE - A - 1 564 694 (BROWN-BOVERI) * Figure 2; page 5, 1er alinéa * | 1,2,4 | **CATEGORIE DES DOCUMENTS CITES** X: particulièrement pertinent A: arrière-plan technologique O: divulgation non-écrite P: document intercalaire T: théorie ou principe à la base de l'invention E: demande faisant interférence D: document cité dans la demande L: document cité pour d'autres raisons &: membre de la même famille, document correspondant |

Le présent rapport de recherche a été établi pour toutes les revendications

| Lieu de la recherche | Date d'achevement de la recherche | Examinateur |
|---|---|---|
| La Haye | 21-05-1980 | DE RAEVE |

OEB Form 1503.1   06.78